# EUROPÄISCHE PATENTSCHRIFT

(11) **EP 3 057 832 B1**
(45) Veröffentlichungstag und Bekanntmachung des Hinweises auf die Patenterteilung: **29.07.2020**
(21) Anmeldenummer: 14776666.1
(22) Anmeldetag: 26.09.2014
(51) Int. Cl.: B60Q 1/14

(54) **LENKSTOCKSCHALTEREINRICHTUNG ZUM BEDIENEN ZUMINDEST EINES MIT EINEM ELEKTRISCHEN LASTSTROM BETRIEBENEN ELEKTRISCHEN VERBRAUCHERS, KRAFTFAHRZEUG UND VERFAHREN ZUM HERSTELLEN EINER LENKSTOCKSCHALTEREINRICHTUNG**
STEERING COLUMN SWITCH DEVICE FOR OPERATING AT LEAST ONE ELECTRIC LOAD WHICH IS DRIVEN BY AN ELECTRIC LOAD CURRENT, MOTOR VEHICLE, AND METHOD FOR PRODUCING A STEERING COLUMN SWITCH DEVICE
DISPOSITIF DE COMMANDE DE COLONNE DE DIRECTION POUR FAIRE FONCTIONNER AU MOINS UN CONSOMMATEUR ÉLECTRIQUE ALIMENTÉ AVEC UN COURANT DE CHARGE ÉLECTRIQUE, VÉHICULE AUTOMOBILE ET PROCÉDÉ DE FABRICATION D'UN DISPOSITIF DE COMMANDE DE COLONNE DE DIRECTION

(30) Priorität: 16.10.2013 DE 102013017246
(43) Veröffentlichungstag der Anmeldung: 24.08.2016
(73) Patentinhaber: Valeo Schalter und Sensoren GmbH, 74321 Bietigheim-Bissingen (DE)
(72) Erfinder: SIMONIS, Karl, 74321 Bietigheim-Bissingen (DE); GRUENER, Roland, 74321 Bietigheim-Bissingen (DE)
(74) Vertreter: Pothmann, Karsten
(86) Internationale Anmeldenummer: PCT/EP2014/070648
(87) Internationale Veröffentlichungsnummer: WO 2015/055402

(56) Entgegenhaltungen:
- WO-A1-2008/155360
- FR-A1- 2 955 969
- US-A1- 2004 003 988

## Beschreibung

Die Erfindung betrifft eine Lenkstockschaltereinrichtung zum Bedienen zumindest eines mit einem elektrischen Laststrom betriebenen elektrischen Verbrauchers eines Kraftfahrzeugs. Die Lenkstockschaltereinrichtung umfasst eine Leiterplatte, auf welcher Leiterbahnen angeordnet sind, die mit elektrisch leitfähigen Kontaktflächen für mit einem Lenkstockhebel bewegliche Kontaktelemente verbunden sind. Die Erfindung betrifft außerdem ein Kraftfahrzeug mit einer solchen Lenkstockschaltereinrichtung sowie ein Verfahren zum Herstellen einer Lenkstockschaltereinrichtung für ein Kraftfahrzeug.

Lenkstockschaltereinrichtungen für Kraftfahrzeuge sind bereits aus dem Stand der Technik in vielfältiger Ausgestaltung bekannt. Es wird grundsätzlich zwischen zwei Varianten von Lenkstockschaltern unterschieden: Es sind Lenkstockschalter bekannt, bei denen beim Betätigen des Lenkstockhebels unmittelbar Lastströme im Lenkstockschaltermodul geschaltet werden, mit denen der zugeordnete elektrische Verbraucher unmittelbar versorgt wird. Andererseits sind auch Varianten von Lenkstockschaltern bekannt, bei denen beim Betätigen des Lenkstockhebels lediglich Steuerströme in dem Lenkstockschaltermodul geschaltet werden, welche wiederum einem Steuergerät zugeführt werden, welches dann abhängig von den Steuerströmen den elektrischen Verbraucher ansteuert. Der elektrische Laststrom fließt bei dieser Variante also nicht über den Lenkstockschalter. Es sind auch Mischvarianten bekannt, bei denen in der Lenkstockschaltereinrichtung einerseits codierte Steuerströme sowie andererseits Lastströme geschaltet werden müssen. Eine solche Lenkstockschaltereinrichtung kann zum Beispiel zwei Lenkstockhebel aufweisen, wobei beim Betätigen eines ersten Hebels die Steuerströme und beim Betätigen des zweiten Hebels die Lastströme geschaltet werden.

Aufgrund der Vielzahl von möglichen Varianten hat sich die Herstellung von Lenkstockschaltereinrichtungen als relativ aufwändig erwiesen. Während bei der Variante mit Steuerströmen üblicherweise eine Leiterplatte mit Leiterbahnen und Kontaktflächen bereitgestellt wird, müssen bei der Variante mit Lastströmen kunststoffumspritzte Stanzteile mit zugeordneten elektrischen Leitungen eingesetzt werden. Wird eine Mischvariante ausgewählt, so muss sowohl eine Leiterplatte als auch ein separates Stanzteil bereitgestellt werden, welches Kontaktflächen aufweist, die für den Laststrom ausgelegt sind. Während die Steuerströme nämlich eine Stromstärke im Milliampere-Bereich - etwa von 1 bis 50 mA - aufweisen, ist die Stromstärke des Laststroms üblicherweise deutlich höher und liegt etwa in einem Wertebereich von 5 bis 10 A, abhängig von dem Verbraucher. Dies gilt für eine Bordnetzspannung von 12 V.

Lenkstockschaltereinrichtungen, bei denen beim Betätigen eines ersten Lenkstockhebels Steuerströme und beim Betätigen eines zweiten Lenkstockhebels Lastströme geschaltet werden müssen, sind demnach relativ aufwändig und kostenintensiv. Außerdem ist es nachteilig, dass sich Widerstände zur Signalcodierung nur schwierig und relativ aufwändig auf den Stanzteilen integrieren lassen. Ein gemeinsamer Stecker, durch welchen sowohl die Steuerströme als auch die Lastströme geführt werden können, ist nur sehr schwer realisierbar.

Eine gattungsgemäße Lenkstockschalteinrichtung ist aus US 2004/0003988 A1 bekannt.

Es ist Aufgabe der Erfindung, eine Lenkstockschaltereinrichtung, ein Kraftfahrzeug sowie ein Verfahren bereitzustellen, welche im Vergleich zum Stand der Technik eine Reduktion des Herstellungsaufwands der Lenkstockschaltereinrichtung ermöglichen.

Diese Aufgabe wird erfindungsgemäß durch eine Lenkstockschaltereinrichtung, durch ein Kraftfahrzeug sowie durch ein Verfahren mit den Merkmalen gemäß den jeweiligen unabhängigen Patentansprüchen gelöst. Vorteilhafte Ausführungen der Erfindung sind Gegenstand der abhängigen Patentansprüche, der Beschreibung und der Figuren.

Eine erfindungsgemäße Lenkstockschaltereinrichtung ist zum Bedienen zumindest eines mit einem elektrischen Laststrom betriebenen elektrischen Verbrauchers eines Kraftfahrzeugs ausgebildet. Die Lenkstockschaltereinrichtung kann zum Beispiel als Lenkstockschaltermodul ausgebildet sein, welches auf die Lenksäule des Kraftfahrzeugs aufgesetzt werden kann. Die Lenkstockschaltereinrichtung kann einen oder mehrere Lenkstockhebel aufweisen. Die Lenkstockschaltereinrichtung umfasst eine Leiterplatte (PCB), auf welcher Leiterbahnen angeordnet sind, die mit elektrisch leitfähigen Kontaktflächen verbunden sind, die mit Kontaktelementen kontaktiert werden, die mit einem Lenkstockhebel bewegt werden. Erfindungsgemäß ist vorgesehen, dass die Leiterbahnen für den Laststrom ausgelegt sind.

Mit anderen Worten sind die Leiterbahnen zum Betrieb mit dem Laststrom ausgebildet und somit derart dimensioniert, dass im Betrieb des Verbrauchers der Laststrom zerstörungsfrei über die Leiterbahnen fließen kann, ohne die Leiterplatte bzw. die Leiterbahnen zu zerstören. Die Leiterbahnen können dabei zum Betrieb mit einer Stromstärke größer als 1A, insbesondere größer als 5A, bevorzugt größer als 10A, geeignet sein. Die erfindungsgemäße Lenkstockschaltereinrichtung hat den Vorteil, dass die auf der Leiterplatte bereitgestellten Leiterbahnen für alle möglichen Varianten der Lenkstockschaltereinrichtung genutzt werden können. Wird die Variante mit Steuerströmen ausgewählt, so können über die Leiterbahnen die Steuerströme an das Steuergerät geführt werden. Bei dieser Variante sind die Leiterbahnen dann überdimensioniert. Wird jedoch die Variante mit dem Laststrom ausgewählt, so kann der Laststrom über die Leiterbahnen zum Verbraucher geführt werden. Es ist auch eine Mischvariante möglich. Es brauchen also keine separaten Stanzteile für die Laststromvariante eingesetzt zu werden, sodass der Aufwand beim Herstellen von Lenkstockschaltereinrichtungen im Vergleich zum Stand der Technik deutlich reduziert wird.

Es sind also unterschiedliche Varianten der Lenkstockschaltereinrichtung möglich:
In einer ersten Variante ist vorgesehen, dass die oben genannten Kontaktflächen zum Schalten von Steuerströmen ausgebildet sind, welche an ein Steuergerät des Verbrauchers abgegeben werden. Abhängig von diesen Steuerströmen steuert das Steuergerät dann den elektrischen Verbraucher an. Bei dieser Variante werden über die Leiterbahnen im Betrieb der Lenkstockschaltereinrichtung die Steuerströme geführt, sodass die Leiterbahnen entsprechend überdimensioniert sind. Die Steuerströme haben nämlich üblicherweise eine Stromstärke, die in einem Wertebereich von 1 bis 50 mA liegt.

In einer zweiten Variante kann vorgesehen sein, dass die Kontaktflächen zum Schalten des Laststroms ausgebildet sind, sodass über die Leiterbahnen im Betrieb der Lenkstockschaltereinrichtung der Laststrom geführt wird.

Wird die Laststromvariante gewählt, so können die Kontaktflächen Flächen eines Anbauteils sein, welches an der Leiterplatte befestigt ist. Diese Variante hat den Vorteil, dass beim Herstellen der Leiterplatte zusammen mit den Leiterbahnen auch erste Kontaktflächen bereitgestellt werden können, welche zum Schalten der Steuerströme ausgebildet sind. Diese Leiterplatte kann dann für alle möglichen Varianten genutzt werden. Wird die Laststromvariante gewählt, so wird an dieser Leiterplatte zusätzlich noch das genannte Anbauteil befestigt, welches somit lediglich bei der Laststromvariante vorhanden ist. Auf diesem Anbauteil sind dann zweite Kontaktflächen angeordnet, welche zum Schalten des Laststroms ausgebildet sind. Für alle Varianten kann somit eine einheitliche Leiterplatte hergestellt werden.

Das genannte Anbauteil kann beispielsweise ein Stanzteil sein, insbesondere ein kunststoffumspritztes Stanzteil. Ein solches Stanzteil kann einerseits ohne viel Aufwand hergestellt werden und eignet sich andererseits besonders gut für das Schalten des Laststroms.

Hinsichtlich der Befestigung hat es sich als vorteilhaft gezeigt, wenn das Anbauteil als SMD-Bauteil (Surface Mounted Device) ausgebildet ist, welches in SMT-Technologie (Surface Mounted Technology) auf der Leiterplatte verlötet ist. Die Leiterplatte kann somit in einem einzigen Herstellungsschritt mit allen möglichen elektronischen Komponenten in SMT-Technologie bestückt werden.

Zum einen kann das Anbauteil in einer Aussparung der Leiterplatte angeordnet sein. Diese Aussparung ist vorzugsweise genau an derjenigen Stelle der Leiterplatte angeordnet, an welcher die oben genannten ersten Kontaktflächen bereitgestellt werden. Wird also die Laststromvariante gewählt, so werden diese ersten Kontaktflächen quasi ausgestanzt. Dies hat den Vorteil, dass das Anbauteil derart an der Leiterplatte befestigt werden kann, dass es mit der Leiterplatte bündig abschließt. Die Kontaktflächen des Anbauteils sind dann genau an der Stelle der ersten Kontaktflächen angeordnet.

Zum anderen kann jedoch auch vorgesehen sein, dass das Anbauteil mit den zweiten Kontaktflächen zum Schalten des Laststroms über den ersten Kontaktflächen auf der Leiterplatte angeordnet ist. Somit braucht an der Leiterplatte selbst nichts verändert zu werden.

Die Erfindung betrifft außerdem ein Kraftfahrzeug, insbesondere einen Personenkraftwagen, mit einer erfindungsgemäßen Lenkstockschaltereinrichtung.

Ein erfindungsgemäßes Verfahren dient zum Herstellen einer Lenkstockschaltereinrichtung zum Bedienen zumindest eines mit einem elektrischen Laststrom betriebenen elektrischen Verbrauchers eines Kraftfahrzeugs. Es wird eine Leiterplatte bereitgestellt, auf welcher elektrisch leitfähige erste Kontaktflächen für mit einem Lenkstockhebel bewegliche Kontaktelemente sowie Leiterbahnen bereitgestellt werden, welche für den Laststrom ausgelegt sind.

Dann wird an der Leiterplatte ein Anbauteil mit zweiten Kontaktflächen befestigt, welche mit den Leiterbahnen elektrisch verbunden werden, und die Leiterplatte wird mit den zweiten Kontaktflächen des Anbauteils und den Leiterbahnen zum Schalten des Laststroms eingesetzt.

Die mit Bezug auf die erfindungsgemäße Lenkstockschaltereinrichtung vorgestellten bevorzugten Ausführungsformen und deren Vorteile gelten entsprechend für das erfindungsgemäße Kraftfahrzeug sowie für das erfindungsgemäße Verfahren.

Weitere Merkmale der Erfindung ergeben sich aus den Ansprüchen, den Figuren und der Figurenbeschreibung.

Die Erfindung wird nun anhand eines bevorzugten Ausführungsbeispiels sowie unter Bezugnahme auf die beigefügten Zeichnungen näher erläutert.

### Es zeigen:

- Fig. 1: in schematischer und perspektivischer Darstellung eine Lenkstockschaltereinrichtung gemäß einer Ausführungsform der Erfindung;
- Fig. 2: die Lenkstockschaltereinrichtung mit einem Anbauteil;
- Fig. 3: in vergrößerter Darstellung das Anbauteil;
- Fig. 4 und 5: Schiebeelemente mit elektrischen Kontaktelementen.

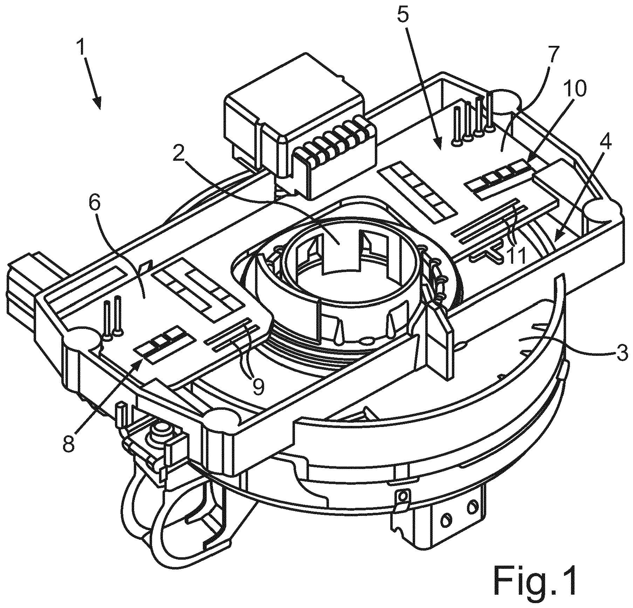

Eine in Fig. 1 dargestellte Lenkstockschaltereinrichtung 1 ist in Form eines Lenksäulenmoduls ausgebildet, welches an einer Lenksäule eines Personenkraftwagens installiert werden kann. Die Lenkstockschaltereinrichtung 1 umfasst ein Nabenteil 2, welches auf die Lenkwelle der Lenksäule aufgesteckt werden kann. Die Lenkstockschaltereinrichtung 1 umfasst des Weiteren ein Gehäuse 3, welches an der Lenksäule ortsfest angeordnet wird. Beim Drehen des Lenkrads wird also lediglich das Nabenteil 2 relativ zum Gehäuse 3 gedreht.

In dem Gehäuse 3 kann auch ein so genannter Flachleiter bzw. eine Wickelfeder angeordnet sein, über welchen/welche elektrische Signale zwischen Einrichtungen einerseits, die sich im Lenkrad befinden, und Steuergeräten andererseits übertragen werden, die ortsfest im Fahrzeug angeordnet sind.

An dem Gehäuse 3 kann ein oder können mehrere Lenkstockhebel befestigt werden, welche dann zum Bedienen unterschiedlicher Verbraucher des Kraftfahrzeugs dienen. Mit einem Lenkstockhebel können zum Beispiel eine Pumpe einer Scheibenwaschanlage und/oder ein Elektromotor eines Scheibenwischers und/oder die Blinker des Kraftfahrzeugs und/oder die Scheinwerfer gesteuert werden.

In dem Gehäuse 3 ist in einer Aufnahme 4 eine Leiterplatte 5 (Platine) angeordnet, welche im Ausführungsbeispiel zum Betrieb mit zwei Lenkstockhebeln ausgebildet ist, nämlich einem linken und einem rechten Lenkstockhebel. Entsprechend ist die Leiterplatte 5 in einen linken und einen rechten Bereich 6, 7 unterteilt. In dem linken Bereich 6 sind erste Kontaktflächen 8 bereitgestellt, welche mit schematisch angedeuteten Leiterbahnen 9 elektrisch gekoppelt sind. Diese Leiterbahnen 9 können alternativ auch an der gegenüberliegenden Rückseite der Leiterplatte 5 angeordnet sein; weiterhin alternativ kann die Leiterplatte 5 auch als mehrlagige Leiterplatte ausgebildet sein, und die Leiterbahnen 9 können in einer inneren Lage der Leiterplatte 5 angeordnet sein.

Entsprechend sind auch in dem rechten Bereich 7 erste Kontaktflächen 10 auf der Leiterplatte 5 ausgebildet, welche mit Leiterbahnen 11 elektrisch verbunden sind, die schematisch angedeutet sind. Auch diese Leiterbahnen 11 können optional an der Rückseite oder aber in einer inneren Lage der Leiterplatte 5 angeordnet sein.

Je nach Variante der Lenkstockschaltereinrichtung 1 werden in dem Gehäuse durch den jeweiligen Lenkstockhebel Lastströme oder Steuerströme geschaltet. Bei dem Laststrom handelt es sich um denjenigen elektrischen Strom, mit welchem der elektrische Verbraucher unmittelbar versorgt wird. Steuerströme stellen hingegen Steuersignale dar, welche an ein Steuergerät abgegeben werden, mittels welchem der Verbraucher wiederum angesteuert wird. Es ist auch eine Mischvariante möglich, bei welcher mit einem Lenkstockhebel die Lastströme und mit einem anderen Lenkstockhebel die Steuerströme geschaltet werden.

Die in Fig. 1 dargestellten ersten Kontaktflächen 8, 10 sind zum Schalten der Steuerströme ausgebildet und entsprechend auch dimensioniert. Diese Kontaktflächen 8, 10 können beispielsweise vergoldet oder versilbert sein. Die Leiterbahnen 9 und/oder die Leiterbahnen 11 sind jedoch zum Betrieb mit dem Laststrom ausgebildet und somit so dimensioniert, dass sie einen elektrischen Strom von 5A bis über 10A führen können. Diese Leiterbahnen 9 und/oder 11 sind also aus einem dickeren Material (zum Beispiel Kupfer) ausgeführt als Leiterbahnen, die lediglich für die Steuerströme im Milliampere-Bereich ausgelegt sind.

Eine solche Leiterplatte 5, wie sie in Fig. 1 dargestellt ist, kann also für alle möglichen Varianten der Lenkstockschaltereinrichtung 1 eingesetzt werden. Wird eine Variante ausschließlich mit Steuerströmen gewählt, so werden diese Steuerströme über die ersten Kontaktflächen 8 bzw. 10 sowie über die Leiterbahnen 9 bzw. 11 geleitet. Die Leiterbahnen 9 und/oder 11 sind dabei überdimensioniert.

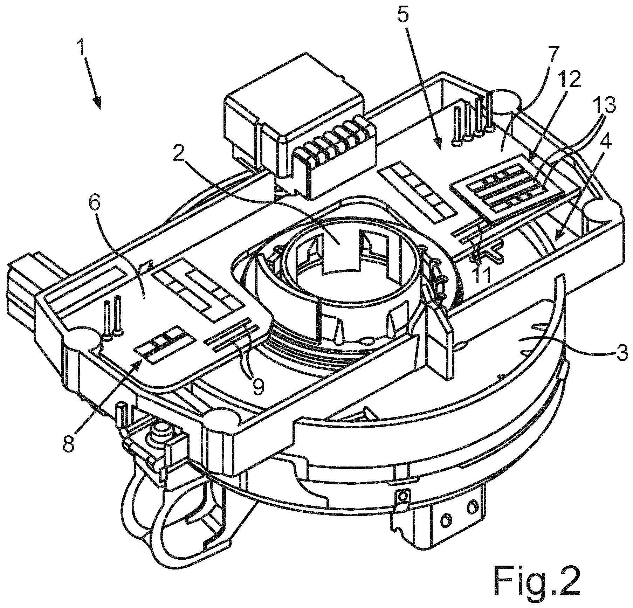

Wird jedoch eine zweite Variante ausgewählt, bei welcher einer der Lenkstockhebel oder beide Lenkstockhebel die Lastströme schalten müssen, so wird ein Anbauteil 12 eingesetzt, wie es in Fig. 2 für den rechten Bereich 7 der Leiterplatte 5 dargestellt ist. Auf diesem Anbauteil 12 sind zweite Kontaktflächen 13 bereitgestellt, welche zum Schalten des Laststroms ausgebildet sind. Diese Kontaktflächen 13 sind also entsprechend so dimensioniert, dass sie mit elektrischem Strom von 5A bis über 10A betrieben werden können. Diese Kontaktflächen 13 werden an die Leiterbahnen 11 angebunden, welche ohnehin bereits für den Laststrom optimiert sind.

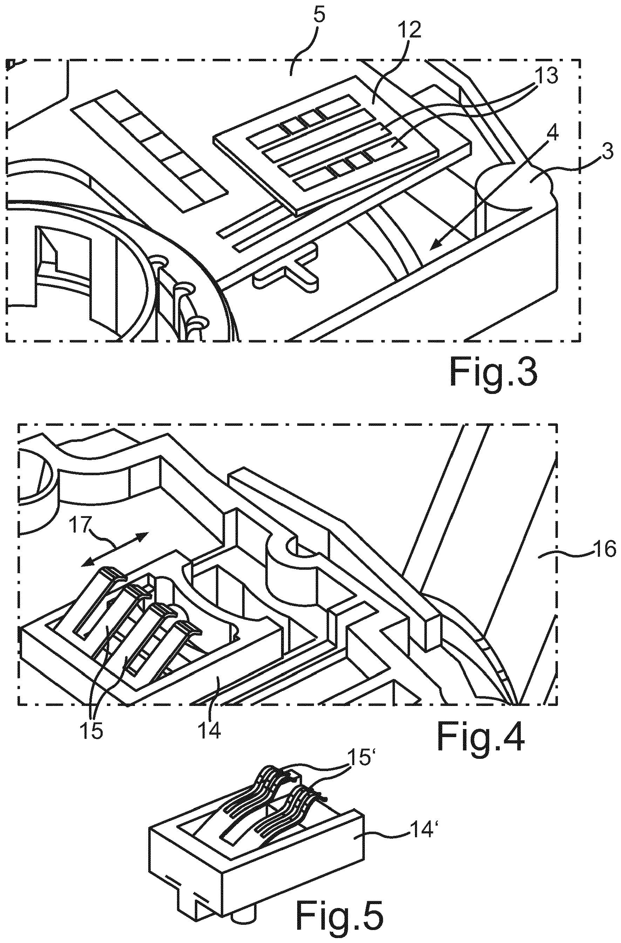

Wie aus Fig. 3 hervorgeht, kann das Anbauteil 12 als kunststoffumspritztes Stanzteil ausgebildet sein, welches an der Leiterplatte 5 direkt über den ersten Kontaktflächen 10 befestigt wird. Diese Befestigung kann zum Beispiel so aussehen, dass das Anbauteil 12 als SMD-Bauteil bereitgestellt und dann auf der Oberfläche der Leiterplatte 5 verlötet wird. Alternativ ist es jedoch auch möglich, in der Leiterplatte 5 eine Aussparung vorzusehen, sodass die ersten Kontaktflächen 10 quasi ausgestanzt werden, und das Anbauteil 12 dann innerhalb dieser Aussparung anzuordnen. Das Anbauteil 12 schließt dann mit der Oberfläche der Leiterplatte 5 bündig ab.

In Fig. 4 ist ein Schiebeelement 14 mit elektrischen Kontaktelementen 15 dargestellt, welche als Federkontakte ausgeführt sind und das Gegenstück für die zweiten Kontaktflächen 13 darstellen. Diese Kontaktelemente 15 sind also zum Schalten des Laststroms ausgebildet. Beim Betätigen eines Lenkstockhebels 16 wird das Schiebeelement 14 zwischen zwei oder mehreren Stellungen gemäß der Pfeildarstellung 17 verschoben. Wird hingegen die Steuerstromvariante gewählt, so wird ein Schiebeelement 14' mit Kontaktelementen 15' eingesetzt, wie sie in Fig. 5 dargestellt sind und zum Schalten der Steuerströme ausgebildet sind. Wie aus den Fig. 4 und 5 hervorgeht, sind die Kontaktelemente 15 für den Laststrom deutlich größer und robuster dimensioniert als die Kontaktelemente 15'. Nach Auswahl der Laststromvariante wird also das Schiebeelement 14 eingesetzt; nach Auswahl der Steuerstromvariante das Schiebeelement 14'.

Bei der Herstellung der Lenkstockschaltereinrichtung 1 wird zunächst die Leiterplatte 5 mit den ersten Kontaktflächen 8 und/oder 10 sowie mit den Leiterbahnen 9 und/oder 11 hergestellt. Dann wird eine Variante der Lenkstockschaltereinrichtung 1 ausgewählt, und zwar aus der ersten Variante (Steuerstromvariante) und der zweiten Variante (Laststromvariante). Bei mindestens zwei Lenkstockhebeln ist auch eine Mischvariante möglich. Wird die erste Variante gewählt, so wird die Leiterplatte 5 verwendet, wie sie in Fig. 1 gezeigt ist. Wird die zweite Variante gewählt, so wird an der Leiterplatte 5 zusätzlich noch das optionale Anbauteil 12 befestigt, und die Leiterplatte 5 wird zusammen mit dem Anbauteil 12 eingesetzt. Bei der ersten Variante wird das Schiebeelement 14' gemäß Fig. 5 eingesetzt, während bei der zweiten Variante das Schiebeelement 14 gemäß Fig. 4 verwendet wird.

Es ist auch möglich, ein solches Anbauteil 12 auch in dem linken Bereich 6 der Leiterplatte 5 einzusetzen. Müssen beide Lenkstockhebel Lastströme schalten, so können auch zwei solche Anbauteile 12 verwendet werden, nämlich sowohl links als auch rechts.

## Patentansprüche

1. Lenkstockschaltereinrichtung (1) zum Bedienen zumindest eines mit einem elektrischen Laststrom betriebenen elektrischen Verbrauchers eines Kraftfahrzeugs, mit einer Leiterplatte (5), auf welcher Leiterbahnen (9, 11) angeordnet sind, welche für den Laststrom ausgelegt sind und mit elektrisch leitfähigen Kontaktflächen (8, 10, 13) für mit einem Lenkstockhebel (16) bewegliche Kontaktelemente (15, 15') verbunden sind,
**dadurch gekennzeichnet, dass**
die Kontaktflächen (13) zum Schalten des Laststroms ausgebildet sind, sodass über die Leiterbahnen (9, 11) der Laststrom geführt ist, wobei die Kontaktflächen (13) Flächen eines Anbauteils (12) sind, welches an der Leiterplatte (5) befestigt ist.

2. Lenkstockschaltereinrichtung (1) nach Anspruch 1,
**dadurch gekennzeichnet, dass**
die Kontaktflächen (8, 10) zum Schalten von Steuerströmen für ein Steuergerät des Verbrauchers ausgebildet sind, sodass über die Leiterbahnen (9, 11) die Steuerströme geführt sind.

3. Lenkstockschaltereinrichtung (1) nach Anspruch 1,
**dadurch gekennzeichnet, dass**
das Anbauteil (12) ein, insbesondere kunststoffumspritztes, Stanzteil ist.

4. Lenkstockschaltereinrichtung (1) nach Anspruch 1 oder 3,
**dadurch gekennzeichnet, dass**
das Anbauteil (12) als SMD-Bauteil ausgebildet ist, welches in SMT-Technologie auf der Leiterplatte (5) verlötet ist.

5. Lenkstockschaltereinrichtung (1) nach einem der Ansprüche 1 bis 4,
**dadurch gekennzeichnet, dass**
das Anbauteil (12) in einer Aussparung der Leiterplatte (5) angeordnet ist.

6. Lenkstockschaltereinrichtung (1) nach einem der Ansprüche 1 bis 4,
**dadurch gekennzeichnet, dass**
auf der Leiterplatte (5) erste Kontaktflächen (8, 10) zum Schalten von Steuerströmen angeordnet sind und das Anbauteil (12) mit zweiten Kontaktflächen (13) zum Schalten des Laststroms über den ersten Kontaktflächen (8, 10) auf der Leiterplatte (5) angeordnet ist.

7. Kraftfahrzeug mit einer Lenkstockschaltereinrichtung (1) nach einem der vorhergehenden Ansprüche.

8. Verfahren zum Herstellen einer Lenkstockschaltereinrichtung (1) zum Bedienen zumindest eines mit einem elektrischen Laststrom betriebenen elektrischen Verbrauchers eines Kraftfahrzeugs, mit den Schritten:
- Bereitstellen einer Leiterplatte (5) für die Lenkstockschaltereinrichtung (1), wobei auf der Leiterplatte (5) elektrisch leitfähige erste Kontaktflächen (8, 10) für mit einem Lenkstockhebel (16) bewegliche Kontaktelemente (15, 15') sowie Leiterbahnen (9, 11) bereitgestellt werden, die für den Laststrom ausgelegt sind,
- Befestigen eines Anbauteils (12) mit zweiten Kontaktflächen (13) an der Leiterplatte (5), welche mit den Leiterbahnen (9, 11) elektrisch verbunden werden, und Einsetzen der Leiterplatte (5) mit den zweiten Kontaktflächen (13) des Anbauteils (12) und den Leiterbahnen (9, 11) zum Schalten des Laststroms.

9. Verfahren nach Anspruch 8,
**dadurch gekennzeichnet, dass**
das Anbauteil (12) als ein, insbesondere kunststoffumspritztes, Stanzteil ausgebildet wird.

10. Verfahren nach Anspruch 8 oder 9,
**dadurch gekennzeichnet, dass**
das Anbauteil (12) als SMD-Bauteil ausgebildet wird, welches in SMT-Technologie auf der Leiterplatte (5) verlötet wird.

11. Verfahren nach einem der Ansprüche 8 bis 10,
**dadurch gekennzeichnet, dass** eine Aussparung in der Leiterplatte (5) ausgebildet wird und das Anbauteil (12) in der Aussparung der Leiterplatte (5) angeordnet wird.

12. Verfahren nach einem der Ansprüche 8 bis 10, **dadurch gekennzeichnet, dass** das Anbauteil (12) mit den zweiten Kontaktflächen (13) auf der Leiterplatte (5) über den ersten Kontaktflächen (8, 10) angeordnet wird.

## Claims

1. Steering column switch device (1) for operating at least one electrical consumer of a motor vehicle that is operated with an electrical load current, having a printed circuit board (5) on which conductor tracks (9, 11) are arranged, which conductor tracks are designed for the load current and are connected to electrically conductive contact areas (8, 10, 13) for contact elements (15, 15') which are movable with a steering column lever (16), **characterized in that**
the contact areas (13) are designed to switch the load current, with the result that the load current is conducted via the conductor tracks (9, 11), wherein the contact areas (13) are areas of an attachment part (12) which is fastened to the printed circuit board (5).

2. Steering column switch device (1) according to Claim 1,
**characterized in that**
the contact areas (8, 10) are designed to switch control currents for a control device of the consumer, with the result that the control currents are conducted via the conductor tracks (9, 11).

3. Steering column switch device (1) according to Claim 1,
**characterized in that**
the attachment part (12) is a punched part, in particular a plastic-encapsulated punched part.

4. Steering column switch device (1) according to Claim 1 or 3,
**characterized in that**
the attachment part (12) is in the form of an SMD device which is soldered on the printed circuit board (5) using SMT technology.

5. Steering column switch device (1) according to one of Claims 1 to 4,
**characterized in that**
the attachment part (12) is arranged in a recess of the printed circuit board (5).

6. Steering column switch device (1) according to one of Claims 1 to 4,
**characterized in that**
first contact areas (8, 10) for switching control currents are arranged on the printed circuit board (5) and the attachment part (12) having second contact areas (13) for switching the load current is arranged above the first contact areas (8, 10) on the printed circuit board (5).

7. Motor vehicle having a steering column switch device (1) according to one of the preceding claims.

8. Method for producing a steering column switch device (1) are operating at least one electrical consumer of a motor vehicle that is operated with an electrical load current, having the steps of:
- providing a printed circuit board (5) for the steering column switch device (1), wherein electrically conductive first contact areas (8, 10) for contact elements (15, 15') which are movable with a steering column lever (16) and conductor tracks (9, 11) which are designed for the load current are provided on the printed circuit board (5),
- fastening an attachment part (12) having second contact areas (13) to the printed circuit board (5), which contact areas are electrically connected to the conductor tracks (9, 11), and using the printed circuit board (5) having the second contact areas (13) of the attachment part (12) and the conductor tracks (9, 11) to switch the load current.

9. Method according to Claim 8,
**characterized in that**
the attachment part (12) is in the form of a punched part, in particular a plastic-encapsulated punched part.

10. Method according to Claim 8 or 9,
**characterized in that**
the attachment part (12) is in the form of an SMD device which is soldered on the printed circuit board (5) using SMT technology.

11. Method according to one of Claims 8 to 10,
**characterized in that**
a recess is formed in the printed circuit board (5) and the attachment part (12) is arranged in the recess of the printed circuit board (5).

12. Method according to one of Claims 8 to 10,
**characterized in that**
the attachment part (12) having the second contact areas (13) is arranged on the printed circuit board (5) above the first contact areas (8, 10).

## Revendications

1. Dispositif commutateur de colonne de direction (1) destiné à actionner au moins un récepteur électrique, qui fonctionne avec un courant de charge électrique, d'un véhicule automobile, comprenant un circuit imprimé (5) sur lequel sont disposées des pistes conductrices (9, 11) qui sont conçues pour le courant de charge et sont reliées à des surfaces de contact (8, 10, 13) électriquement conductrices pour des éléments de contact (15, 15') déplaçables avec un levier de colonne de direction (16), **caractérisé en ce que**
les surfaces de contact (13) sont configurées pour commuter le courant de charge, de sorte que le courant de charge est acheminé par le biais des pistes conductrices (9, 11), les surfaces de contact (13) étant des surfaces d'un composant rapporté (12) qui est fixé au circuit imprimé (5).

2. Dispositif commutateur de colonne de direction (1) selon la revendication 1, **caractérisé en ce que** les surfaces de contact (8, 10) sont configurées pour commuter des courants de commande pour un contrôleur du récepteur, de sorte que les courants de commande sont acheminés par le biais des pistes conductrices (9, 11).

3. Dispositif commutateur de colonne de direction (1) selon la revendication 1, **caractérisé en ce que** le composant rapporté (12) est une pièce estampée, notamment surmoulée de matière plastique.

4. Dispositif commutateur de colonne de direction (1) selon la revendication 1 ou 3, **caractérisé en ce que** le composant rapporté (12) est réalisé sous la forme d'un composant CMS qui est brasé sur le circuit imprimé (5) par la technologie du montage en surface.

5. Dispositif commutateur de colonne de direction (1) selon l'une des revendications 1 à 4, **caractérisé en ce que** le composant rapporté (12) est disposé dans une cavité du circuit imprimé (5).

6. Dispositif commutateur de colonne de direction (1) selon l'une des revendications 1 à 4, **caractérisé en ce que** des premières surfaces de contact (8, 10) destinées à commuter des courants de commande sont disposées sur le circuit imprimé (5) et le composant rapporté (12) pourvu de deuxièmes surfaces de contact (13) destinées à commuter le courant de charge est disposé au-dessus des premières surfaces de contact (8, 10) sur le circuit imprimé (5).

7. Véhicule automobile équipé d'un dispositif commutateur de colonne de direction (1) selon l'une des revendications précédentes.

8. Procédé de fabrication d'un dispositif commutateur de colonne de direction (1) destiné à actionner au moins un récepteur électrique, qui fonctionne avec un courant de charge électrique, d'un véhicule automobile, comprenant les étapes suivantes :
- fourniture d'un circuit imprimé (5) pour le dispositif commutateur de colonne de direction (1), des premières surfaces de contact (8, 10) électriquement conductrices pour des éléments de contact (15, 15') déplaçables avec un levier de colonne de direction (16) ainsi que des pistes conductrices (9, 11) qui sont conçues pour le courant de charge étant fournies sur le circuit imprimé (5),
- fixation au circuit imprimé (5) d'un composant rapporté (12) comprenant des deuxièmes surfaces de contact (13), lesquelles sont reliées électriquement aux pistes conductrices (9, 11), et utilisation du circuit imprimé (5) pourvu des deuxièmes surfaces de contact (13), du composant rapporté (12) et des pistes conductrices (9, 11) pour commuter le courant de charge.

9. Procédé selon la revendication 8, **caractérisé en ce que** le composant rapporté (12) est réalisé sous la forme d'une pièce estampée, notamment surmoulée de matière plastique.

10. Procédé selon la revendication 8 ou 9, **caractérisé en ce que** le composant rapporté (12) est réalisé sous la forme d'un composant CMS qui est brasé sur le circuit imprimé (5) par la technologie du montage en surface.

11. Procédé selon l'une des revendications 8 à 10, **caractérisé en ce qu'**une cavité est formée dans le circuit imprimé (5) et le composant rapporté (12) est disposé dans la cavité du circuit imprimé (5).

12. Procédé selon l'une des revendications 8 à 10, **caractérisé en ce que** le composant rapporté (12) pourvu des deuxièmes surfaces de contact (13) est disposé sur le circuit imprimé (5) au-dessus des premières surfaces de contact (8, 10) .
